# EUROPEAN PATENT APPLICATION

(11) **EP 2 728 747 A1**
(43) Date of publication of application: **07.05.2014**
(21) Application number: 13185834.2
(22) Date of filing: 24.09.2013
(51) Int. Cl.: H03G 3/00, H03G 3/30, H03F 1/30, H03F 3/24, H04W 52/52, H04B 1/04

(54) **Amplification output control device and amplification output control method**

(30) Priority: 30.10.2012 JP 2012238875
(71) Applicant: FUJITSU LIMITED, Kawasaki-shi, Kanagawa 211-8588 (JP)
(72) Inventor: Kawasaki, Katsuhiko, Kawasaki-shi, Kanagawa 211-8588 (JP); Manpo, Mitsuhiko, Kawasaki-shi, Kanagawa 211-8588 (JP); Takahashi, Shigeki, Kawasaki-shi, Kanagawa 211-8588 (JP)
(74) Representative: Stebbing, Timothy Charles

(57) **Abstract**

An amplification output control device includes: a determination unit that determines whether or not a gain of a power amplifier varies based on a monitor value of input power from a driver amplifier to the power amplifier, and, when determining that the gain varies, outputs a monitor value of output power of the power amplifier to a driver control unit to cause the driver control unit to execute control of a bias voltage of the driver amplifier; and a control unit that determines whether or not the gain varies based on the monitor value of the output power of the power amplifier when determining that the gain does not vary based on the monitor value of the input power to the power amplifier, and, when determining that the gain varies, controls the bias voltage of the power amplifier.

## Description

### [TECHNICAL FIELD]

The present invention relates to an amplification output control device and method that control output of a power amplifier.

### [BACKGROUND ART]

In radio portable terminals such as a portable telephone terminal, a smartphone and a mobile tablet terminal, reduction in cost and size of terminals themselves is one problem. With this, reduction in cost and size of the processing units for radio signals that are loaded on radio portable terminals is desired.

In order to reduce the cost and size of a processing unit for radio signals, for example, a processing unit for radio signals that is not loaded with an isolator for suppressing influence of reflected waves from an antenna end is sometimes adopted.

### [Prior Art]

[Patent document 1] Japanese Patent Laid-Open No. 2009-004843
[Patent document 2] Japanese Patent Laid-Open No. 2009-525695
[Patent document 3] Japanese Patent Laid-Open No. 2001-332985
[Patent document 4] Japanese Patent Laid-Open No. 2000-514976
[Patent document 5] Japanese Patent Laid-Open No. 2009-278225

### [BRIEF OF THE INVENTION]

However, when an isolator is not loaded on a processing unit for radio signals, the reflected wave from an antenna end returns to a power amplifier, and a load such as impedance sometimes varies. As a result of a load variation, transmission quality of radio signals sometimes degrades.

One aspect of an embodiment is an amplification output control device including: a determination unit that determines presence or absence of a gain variation of a power amplifier, based on a monitor value of input power from a driver amplifier to the power amplifier, and, when it is determined that the gain variation of the power amplifier is present, outputs a monitor value of output power of the power amplifier to a driver control unit to cause the driver control unit to execute control of a bias voltage of the driver amplifier, wherein the driver control unit controls the bias voltage of the driver amplifier in response to the monitor value of the output power of the power amplifier; and a control unit that determines the presence or absence of the gain variation of the power amplifier based on the monitor value of the output power of the power amplifier when it is determined that the gain variation of the power amplifier is absent based on the monitor value of the input power to the power amplifier, and, when it is determined that the gain variation of the power amplifier is present, controls a bias voltage of the power amplifier.

Another aspect of an embodiment is an amplification output control method of the aforementioned amplification output control device executing the aforementioned process. Further, another aspect of the present invention can include a program that causes a computer to function as the amplification output control device described above, and a computer readable recording medium on which the program is recorded. The recording medium that is readable by a computer or the like refers to a recording medium in which information such as data and a program is accumulated by an electric, magnetic, optical, mechanical or chemical action, and can be read from a computer or the like.

According to the disclosed amplification output control device and amplification output control method, output of the power amplifier can be stabilized.

### [BRIEF DESCRIPTION OF THE DRAWINGS]

Fig. 1 is a diagram illustrating one example of a transceiver;
Fig. 2 is a diagram illustrating another example of the transceiver;
Fig. 3 is a diagram illustrating a transceiver in which the transceiver of Fig. 1 and the transceiver of Fig. 2 are combined;
Fig. 4 is a diagram illustrating one example of a configuration of a transceiver in a first embodiment;
Fig. 5 is one example of a load variation lookup table;
Fig. 6 is a diagram illustrating one example of a PA bias lookup table;
Fig. 7A is a chart illustrating one example of processing of transmission power control of the transceiver;
Fig. 7B illustrates a flowchart of bias voltage control processing for a driver amplifier that is executed in APC; and
Fig. 7C is one example of a flowchart of bias voltage control processing of a power amplifier by a PA bias control circuit.

### [DESCRIPTION OF EMBODIMENTS]

Hereinafter, an embodiment of the present invention will be described based on the drawings. A configuration of the following embodiment is merely an illustration, and the present invention is not limited to the configuration of the embodiment.

### <Example of Transceiver>

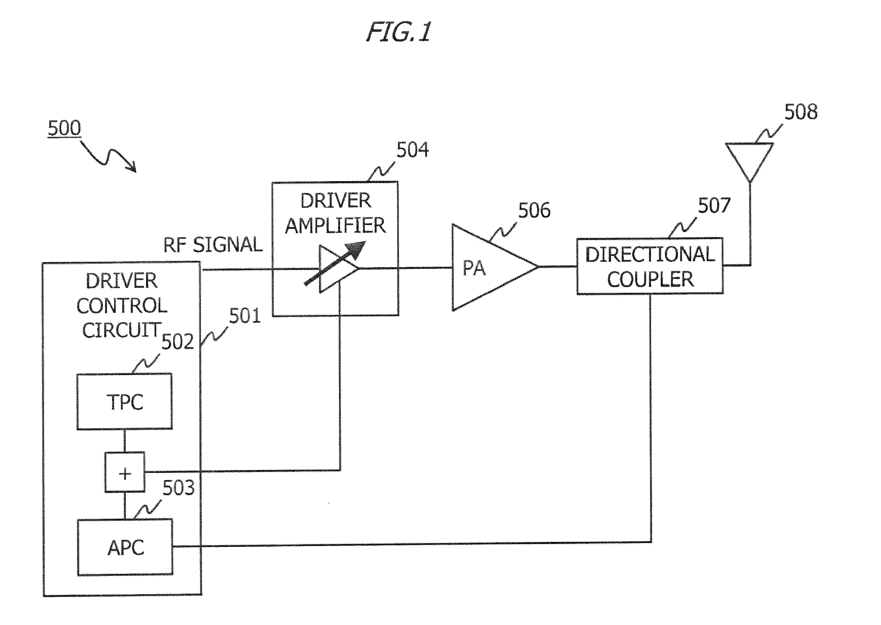

Fig. 1 is a diagram illustrating one example of a transceiver. A transceiver 500 is, for example, a processing unit for radio signals that is loaded on a portable terminal such as a portable telephone terminal, a smartphone and a tablet terminal. Further, in Fig. 1, a configuration relating to transmission processing of the transceiver 500 is illustrated, and a configuration relating to reception processing is omitted.

The transceiver 500 includes a driver control circuit 501, a driver amplifier 504, a power amplifier (PA) 506, a directional coupler 507 and an antenna 508.

The driver amplifier 504 and the power amplifier 506 respectively amplify a transmission signal with predetermined gains. The gain of the driver amplifier 504 is changeable by setting, and by adjusting the gain of the driver amplifier 504, output power of the transceiver 500 can be adjusted to a desired value. Note that the gain of the driver amplifier is set at a predetermined value at a time of use. The power amplifier 506 is of a specification in which the gain is fixed to a predetermined value.

In the amplifiers including the driver amplifier 504 and the power amplifier 506, output power becomes large when the gain becomes large, and when the gain becomes small, the output power becomes small. Further, the gain of the amplifier varies depending on a load variation such as impedance in the amplifier, and an external factor such as a temperature change. Further, the amplifier has a property that the gain declines when the temperature rises, and the gain rises when the temperature lowers.

The directional coupler 507 takes out a part of the output power of the power amplifier 506, and outputs the part of the output power to the driver control circuit 501 as a monitor value of the output power of the power amplifier.

The driver control circuit 501 supplies a bias voltage to the driver amplifier 504. The driver control circuit 501 includes TPC (Transmission Power Control) 502 and APC (Auto Power Control) 503. The TPC 502 controls the bias voltage of the driver amplifier so that output power from the antenna 508 becomes constant, in accordance with an instruction from a base station.

The APC 503 controls variation of the output power corresponding to gain variations of the power amplifier 506 and the driver amplifier 504. The APC 503 detects the variation of the gain of the power amplifier 506 from a monitor value of the output power of the power amplifier 506. The APC 503 controls the bias voltage of the driver amplifier 504 independently from the TPC 502 and supplementally to the TPC 502, in order to correct the variation of the output power corresponding to the variation of the gain of the power amplifier 506. More specifically, the APC 503 outputs a correction value that corresponds to the monitor value of the output power of the power amplifier 506, and is to be added to the bias voltage that is outputted from the TPC 502. The bias voltage of the driver amplifier 504 is controlled, whereby input power of the power amplifier 506 is controlled, and the variation of the output power corresponding to the gain variation of the power amplifier 506 can be corrected.

For example, when the monitor value of the output power of the power amplifier 506 drops, the APC 503 performs such control as to raise the bias voltage of the driver amplifier 504. By raising the bias voltage of the driver amplifier 504, the output power of the driver amplifier 504, that is, the input power of the power amplifier 506 becomes large. Further, by raising the bias voltage of the driver amplifier 504, the driver amplifier 504 can be compensated for the output power which is reduced in response to reduction in the gain due to an external factor such as a temperature change. The input power of the power amplifier 506 becomes large, whereby the output power of the power amplifier 506 becomes large, and the power amplifier 506 can be compensated for the output power which is reduced in response to reduction in the gain due to an external factor such as a temperature change.

As above, the APC 503 controls the bias voltage of the driver amplifier 504, and thereby controls the output power of the transceiver 500. Further, control of the bias voltage of the driver amplifier 504 by the APC 503 is more effective when the output power of the transceiver 500 varies due to variations of the gains of the power amplifier 506 and the driver amplifier due to an external factor such as a temperature change.

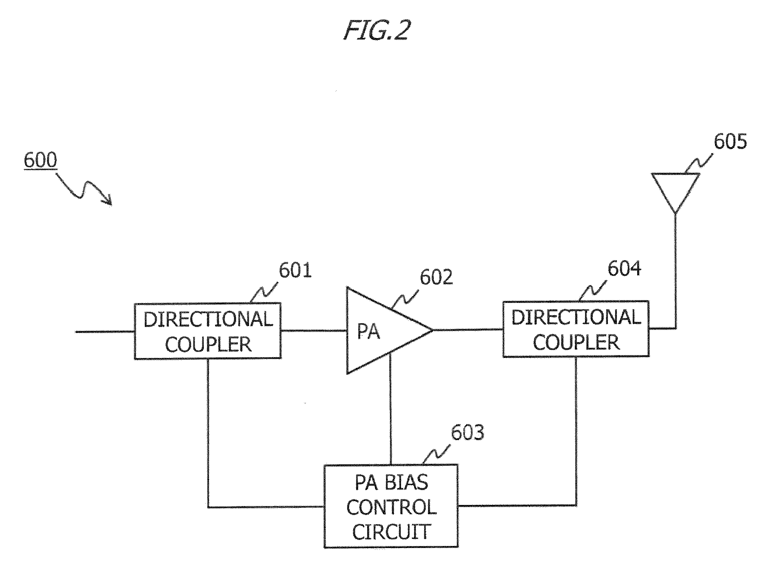

Fig. 2 is a diagram illustrating another example of the transceiver. When an isolator is not loaded, a gain of a power amplifier varies with a load variation such as impedance in the power amplifier by a reflected wave from an antenna. For example, when the gain of the power amplifier becomes small, output power of the power amplifier becomes small, and transmission quality sometimes degrades by receiving influence of leakage power from an adjacent channel. A transceiver 600 illustrated in Fig. 2 is not loaded with an isolator, and controls a bias voltage of a power amplifier 602 in order to suppress degradation of the transmission quality by reflected waves from an antenna 605.

The transceiver 600 includes directional couplers 601 and 604 at an input side and an output side of the power amplifier 602, and a PA bias control circuit 603 that controls the bias voltage of the power amplifier 602. The PA bias control circuit 603 obtains a monitor value of input power and a monitor value of output power respectively from the directional couplers 601 and 604, calculates a gain of the power amplifier 602 from these values, and controls the bias voltage of the power amplifier 602 in response to the gain. Namely, the PA bias control circuit 603 controls the output power of the transceiver 600 by controlling the bias voltage of the power amplifier 602.

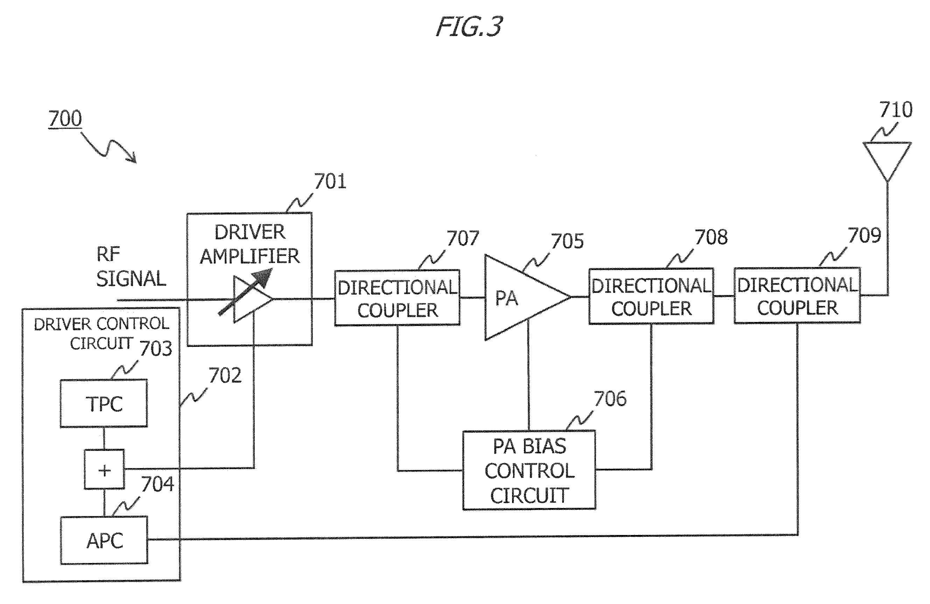

Fig. 3 is a diagram illustrating one example of a transceiver in which the transceiver 500 of Fig. 1 and the transceiver 600 of Fig. 2 are combined. By including APC, a variation in the gain of a power amplifier due to an external factor such as a temperature change can be handled. Further, by including a PA bias control circuit, a variation in the gain due to a load variation by a reflected wave from an antenna can be handled. A transceiver 700 has both configurations of the transceiver 500 and the transceiver 600, and thereby handles the variations in the gain due to an external factor such as a temperature change and the load variation by a reflected wave.

The transceiver 700 includes a driver amplifier 701, a driver control circuit 702, a power amplifier 705, a PA bias control circuit 706, directional couplers 707 to 709, and an antenna 710. The driver control circuit 702 includes a TPC 703 and an APC 704. The driver amplifier 701, the driver control circuit 702 and the directional coupler 709 correspond to the driver amplifier 504, the driver control circuit 501 and the directional coupler 507 of the transceiver 500 of Fig. 1. The PA bias control circuit 706 and the directional couplers 707 and 708 correspond to the PA bias control circuit 603 and the directional couplers 601 and 604 of the transceiver 600 of Fig. 2.

In the transceiver 700, control of a bias voltage of the driver amplifier 701 due to a temperature change or the like by the APC 704, and control of a bias voltage of the power amplifier 705 by the PA bias control circuit 706 are independently performed respectively. Thereby, for example, the event as follows is likely to occur.

When output power of the power amplifier 705 decreases, the bias voltage of the driver amplifier 701 is controlled by the driver control circuit 702 (APC 704) so that the output power of the power amplifier 705 becomes large. Meanwhile, the PA bias control circuit 706 also controls the bias voltage of the power amplifier 705 in order to increase the output power of the power amplifier 705. Namely, in both the APC 704 and the PA bias control circuit 706, control for increasing the output power of the power amplifier 705 is independently executed respectively. By the control that increases the output power of the power amplifier 705 being doubly performed, the output power of the power amplifier 705 sometimes increases excessively.

Similarly to the above, when the output power of the power amplifier 705 increases, control for decreasing the output power of the power amplifier 705 is doubly executed by the APC 704 and the PA bias control circuit 706. Thereby, the output power of the power amplifier 705 is sometimes reduced excessively.

When the control of the bias voltage of the driver amplifier 701 by the APC 704, and control of the bias voltage of the power amplifier 705 by the PA bias control circuit 706 are simply combined like this, contradiction sometimes arises in the output power of the power amplifier 705. Namely, by executing control responding to the gain variation due to an external factor such as a temperature change (control by the APC), and control responding to the gain variation due to the load variation by a reflected wave (control by the PA bias control circuit), the output power of the power amplifier sometimes becomes unstable conversely.

### <First Embodiment>

In the first embodiment, the transceiver executes both the control responding to the gain variation due to the load variation by a reflected wave and the control responding to the gain variation due to an external factor such as a temperature change without making the output power unstable. More specifically, in the first embodiment, the transceiver determines whether or not a gain variation due to an external factor such as a temperature change is present, based on the monitor value of the input power of the power amplifier. When the transceiver determines that the gain variation due to an external factor such as a temperature change is present, the transceiver controls the output power by controlling the bias voltage of the driver amplifier. When the transceiver determines that the gain variation due to an external factor such as a temperature change is absent, the transceiver next determines presence or absence of a gain variation due to a load variation by a reflected wave, based on the monitor value of the output power of the power amplifier. When the transceiver determines that a gain variation due to the load variation by a reflected wave is present, the transceiver controls the output power by controlling the bias voltage of the power amplifier without controlling the bias voltage of the driver amplifier.

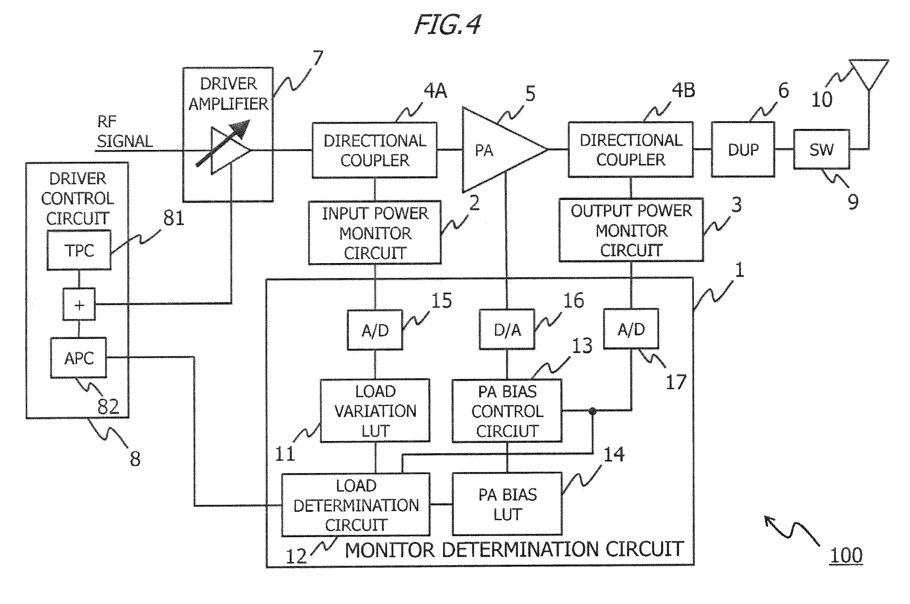

Fig. 4 is a diagram illustrating one example of a configuration of the transceiver in the first embodiment. A transceiver 100 is, for example, a processing unit for a radio signal that is loaded on a portable terminal including a radio communication function, such as a portable telephone terminal, a smartphone, and a mobile tablet terminal. Further, in Fig. 4, a configuration of a transmission side of the transceiver 100 is illustrated, and a configuration of a reception side is omitted. The transceiver 100 is one example of an "amplification output control device".

The transceiver 100 includes a monitor determination circuit 1, an input power monitor circuit 2, an output power monitor circuit 3, directional couplers 4A and 4B, a power amplifier 5, a duplexer (DUP in the drawing) 6, a driver amplifier 7, a driver control circuit 8, a switch (SW in the drawing) 9 and an antenna 10.

The driver amplifier 7 is an amplifier capable of adjustment of a gain. By adjusting a gain of the driver amplifier 7, transmission power of the transceiver 100 can be adjusted to a desired value. The driver control circuit 8 controls a bias voltage of the driver amplifier 7. The driver control circuit 8 includes a TPC 81 and an APC 82, and controls the bias voltage of the driver amplifier 7 thereby. The TPC 81 performs control of the bias voltage of the driver amplifier 7 based on an instruction from a base station. The APC 82 performs control of the bias voltage of the driver amplifier 7 supplementally to the TPC 81, based on a variation of output power of the power amplifier 5. The driver control circuit 8 and the APC 82 are one example of a "driver control unit".

The directional couplers 4A and 4B respectively cause input power and the output power of the power amplifier 5 to branch to the input power monitor circuit 2 and the output monitor circuit 3. The directional couplers 4A and 4B are also called couplers. The input power and the output power that are caused to branch by the directional couplers 4A and 4B have low voltages. The input monitor circuit 2 and the output monitor circuit 3 are circuits that respectively amplify and shape the input power and the output power that are caused to branch by the directional couplers 4A and 4B to such a level as to be capable of being subjected to analog-digital conversion. Signals that are outputted from the input monitor circuit 2 and the output monitor circuit 3 are inputted in the monitor determination circuit 1. The input monitor circuit 2 and the output monitor circuit 3 are, for example, detector circuits.

Power of the signal outputted from the input monitor circuit 2 and power of the signal outputted from the output monitor circuit 3 will be hereinafter called an input power monitor value and an output power monitor value respectively. The input power monitor value and the output power monitor value are measured at predetermined periods, and are respectively stored in buffers (not illustrated) for the input power monitor value and for the output power monitor value that are included in the monitor determination circuit 1. Further, two that are a measured value of a previous time and a measured value of this time are buffered in the buffer for the output power monitor value. The predetermined periods at which the input power monitor value and the output power monitor value are measured are each, for example, 660 micro seconds that is execution timing for control processing of the APC 82.

The duplexer 6 switches transmission and reception of a radio signal via the antenna 10. When the transceiver 100 includes radio units of a plurality of radio systems (3G, LTE, WiMAX and the like), or when the transceiver 100 includes radio units for a plurality of frequencies respectively, the switch 9 switches the radio unit that is to be connected to the antenna 10.

The monitor determination circuit 1 includes a load variation lookup table (LUT) 11, a load determination circuit 12, a PA bias control circuit 13, a PA bias lookup table (LUT) 14, analog-digital converters 15 and 17, and a digital-analog convertor 16.

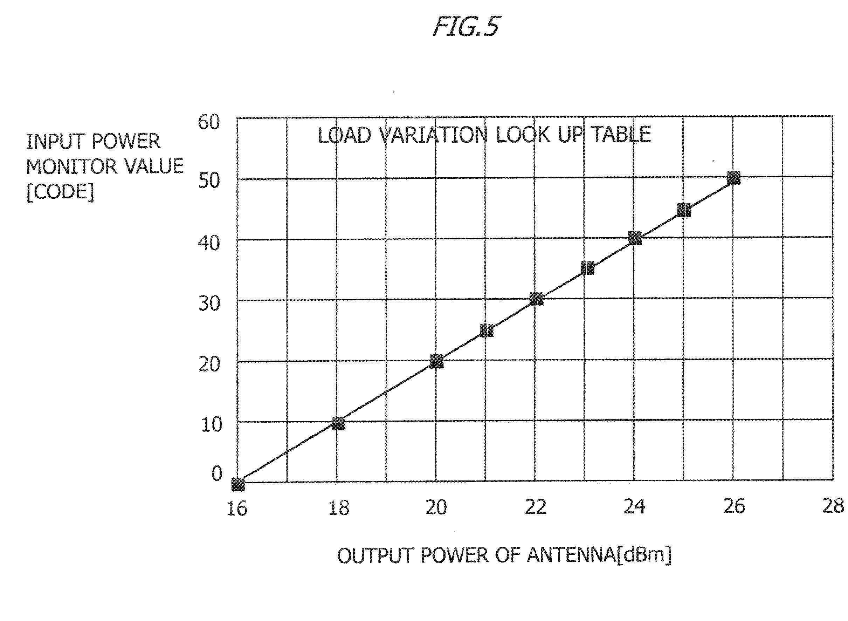

The load variation lookup table 11 stores a reference value of the input power monitor value of the power amplifier 5 in a predetermined condition. The predetermined condition is, for example, a reference temperature, and the reference value is the input power monitor value of the power amplifier 5 at the reference temperature. The reference temperature is, for example, 25°C. The load variation lookup table 11 is stored, for example, in a part of a storage region of a nonvolatile memory included in the monitor determination circuit 1. The details of the load variation lookup table 11 will be described in Fig. 5 that will be described later. The load variation lookup table 11 is one example of a "storage unit".

The load determination circuit 12 detects gain variations of the power amplifier 5 and the driver amplifier 7 due to an external factor such as a temperature change by determining whether or not the input power monitor value varies from the reference value stored in the load variation lookup table 11. Similarly to the power amplifier 5, in the driver amplifier 7 that is located in a preceding stage of the power amplifier 5, the gain also varies due to the external factor such as a temperature change. Further, the gain of the power amplifier 5 also varies due to a factor (for example, a load variation by the reflected wave from the antenna end) other than an external factor such as a temperature change. Meanwhile, the gain variation due to a load variation is absorbed by the power amplifier 5 in a post stage, and therefore, as the gain variation of the driver amplifier 7, the gain variation which is due to the factors other than the external factor such as a temperature change is very small. Therefore, in the transceiver 100, the gain variation due to the external factor such as a temperature change is detected by detecting the variation of the output power from the driver amplifier 7, that is, the input power monitor value.

When the input power monitor value varies from the reference value stored in the load variation lookup table 11, it is detected that the gains of the driver amplifier 7 and the power amplifier 5 are varied by the temperature varying from the reference temperature. In this case, in order to cause the APC 82 to control the bias voltage of the driver amplifier 7, the load determination circuit 12 feeds back the output power monitor value to the APC 82. Further, in this case, the load determination circuit 12 does not drive the PA bias control circuit 13. The load determination circuit 12 is one example of a "determination unit".

The APC 82 retains, for example, the reference value of the output power monitor value at the reference temperature, and a reference table that stores correction values to the bias voltage of the driver amplifier 7 by the TPC 81 that correspond to the output power monitor values. The reference temperature is, for example, 25°C. Further, the APC 82 has a buffer in which the output power monitor value inputted from the load determination circuit 12 is stored.

The APC 82 controls the correction value for the bias voltage of the driver amplifier 7 by the TPC 81 when the output power monitor value varies from the reference value. The APC 82 obtains the correction value corresponding to the output power monitor value from the reference table and outputs the correction value. The correction value is added to the bias voltage of the driver amplifier 7 from the TPC 81, and the bias voltage to which the correction value is added is inputted in the driver amplifier 7. For example, when the output power monitor value becomes small, it is determined that the temperature rises, and the gain is reduced, and in order to increase the output power of the driver amplifier 7 and the power amplifier 5, the correction value becomes a larger value. When the output power monitor value becomes large, it is determined that the temperature is lowered and the gain is increased, and in order to decrease the output power of the driver amplifier 7 and the power amplifier 5, the correction value becomes a smaller value.

When a variation of the input power monitor value from the reference value that is stored in the load variation lookup table 11 is not detected, the load determination circuit 12 drives the PA bias control circuit 13. Further, the load determination circuit 12 transmits a standby signal or the reference value of the output power monitor value at the reference temperature to the APC 82, in order that control of the bias voltage of the driver amplifier 7 by the APC 82 is not performed. This is because when the input power monitor value does not vary from the reference value, it is determined that the gain variation of the power amplifier 5 due to a temperature change or the like does not occur.

The PA bias control circuit 13 detects the gain variation of the power amplifier 5 due to the load variation by a reflected wave by determining whether or not the output power monitor value varies from the reference value of the output power of the power amplifier 5. In the first embodiment, the reference value of the output power of the power amplifier 5 is set at the output power monitor value at the previous time. When the gain variation of the power amplifier 5 due to the load variation by the reflected wave is detected, the PA bias control circuit 13 determines the bias voltage of the power amplifier 5 in response to the output power monitor value, and supplies the bias voltage to the power amplifier 5. Hereinafter, the bias voltage of the power amplifier 5 will be called a PA bias voltage. The PA bias control circuit 13 is one example of a "control unit".

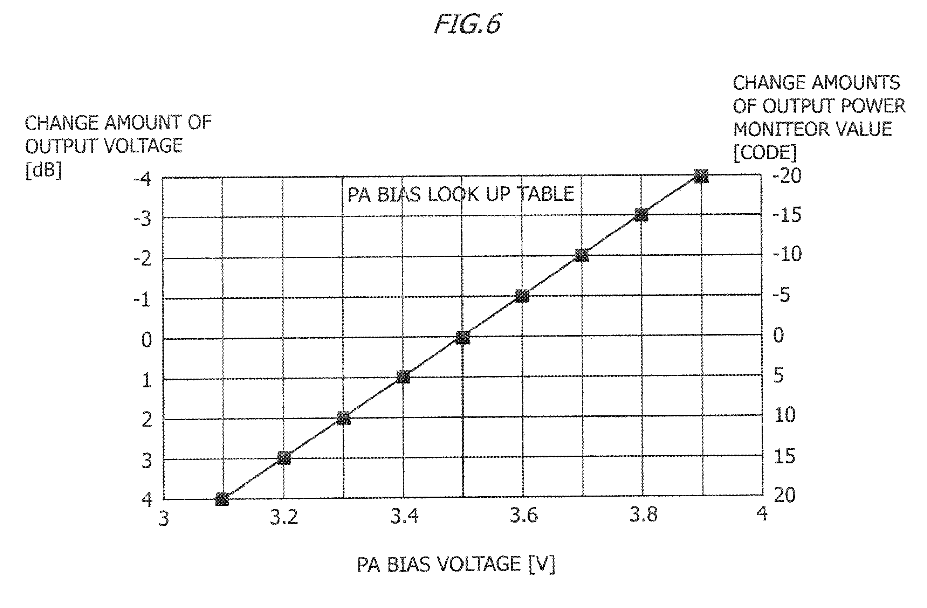

The PA bias voltage based on the output power monitor value of the power amplifier 5 is stored in the PA bias lookup table 14. The PA bias lookup table 14 is stored in, for example, a storage region of a nonvolatile memory that is included in the monitor determination circuit 1. The details of the PA bias lookup table 14 will be described in Fig. 6 that will be described later. The PA bias lookup table 14 is one example of a "second storage unit".

The monitor determination circuit 1 is constructed on, for example, an FPGA (Field-Programmable Gate Array). Further, the monitor determination circuit 1 may be, for example, an IC chip for control such as a base band processor. Further, processing of the load determination circuit 12 and the PA bias control circuit 13 of the monitor determination circuit 1 may be software processing by execution of a program that is stored in a memory of a processor.

Fig. 5 is one example of the load variation lookup table 11. The load variation lookup table 11 stores the reference value of the input power monitor value in predetermined conditions. The load variation lookup table 11 illustrated in Fig. 5 is created by acquiring, in advance, an input power monitor value (code) corresponding to the output power (dBm) of the antenna 10 in the case of the reference temperature set at 25°C and the reference value of the PA bias voltage set at 3.5 V. Further, the load variation lookup table 11 is created on the precondition that a load variation of the power amplifier 5 and thereafter by the reflected wave or the like from the antenna end is not present. A unit "code" of the input power monitor value is a unit for the result of the voltage, which corresponds to the input power after being subjected to analog-digital conversion by the analog-digital converter 15, being converted by a predetermined method for a processor or the like to read, for example.

For example, when the driver control circuit 8 controls the bias voltage of the driver amplifier 7 with the output power of 24 dBm of the antenna 10 as a target, the load determination circuit 12 obtains a code "40" of the input power monitor value corresponding to the antenna output power of 24 dBm from the load variation lookup table 11. The code "40" of the input power monitor value is the reference value of the input power monitor value in the case of the driver control circuit 8 controlling the bias voltage of the driver amplifier 7 with the output power of 24 dBm of the antenna 10 as the target at the reference temperature of 25°C.

When the code of the input power monitor value that is obtained by the input power monitor circuit 2 is, for example, "35", the code varies from the code "40" of the reference value, and therefore, the load determination circuit 12 outputs the output power monitor value to the APC 82. The APC 82 determines the correction value of the bias voltage of the driver amplifier 7 of the TPC 81 so that the output power of the antenna 10 becomes 24 dBm that is the target, in response to the output power monitor value. In this case, it is predicted that the gain of the driver amplifier 7 is reduced, and the temperature rises, since the input power monitor value is smaller than the reference value, and therefore, the bias voltage of the driver amplifier 7 is controlled to be larger.

Fig. 6 is a diagram illustrating one example of the PA bias lookup table 14. The PA bias lookup table 14 stores the PA bias voltage based on output power monitor value. In the PA bias lookup table 14 illustrated in Fig. 6, the PA bias voltages corresponding to change amounts from the previous values of the output power monitor values are stored. The PA bias lookup table 14 illustrated in Fig. 6 is a table that is created by acquiring, in advance, the PA bias voltage corresponding to the antenna output in the case of the reference temperature set as 25°C, and the reference value of the PA bias voltage set as 3.5 V. In Fig. 6, the change amounts of the output power monitor value indicated in code are illustrated on the right side as one faces the figure. The change amounts of the output power indicated in dB that correspond to the change amounts of the output power monitor value indicated in code are illustrated on the left side as one faces the figure. Note that the PA bias lookup table 14 is created on the precondition that there is no temperature change.

In the first embodiment, when it is determined that a variation of the input power monitor value from the reference value is absent by the load determination circuit 12, the PA bias control circuit 13 acquires the change amount of the output power monitor value of this time (change amount of the output power monitor value) from the output power monitor value of the previous time. The PA bias control circuit 13 acquires the PA bias voltage corresponding to the change amount of the output power monitor value from the PA bias lookup table 14.

For example, when the output power monitor value of the previous time is code "40", and the output power monitor value of this time is code "35", the PA bias control circuit 13 finds that the change amount of the output power monitor value is code "-5". In the PA bias lookup table 14 illustrated in Fig. 6, the PA bias voltage corresponding to the code "-5" of the change amount of the output power monitor value is "3.6 V". Accordingly, the PA bias control circuit 13 supplies a PA bias voltage of 3.6 V to the power amplifier 5.

### <Flow of Processing>

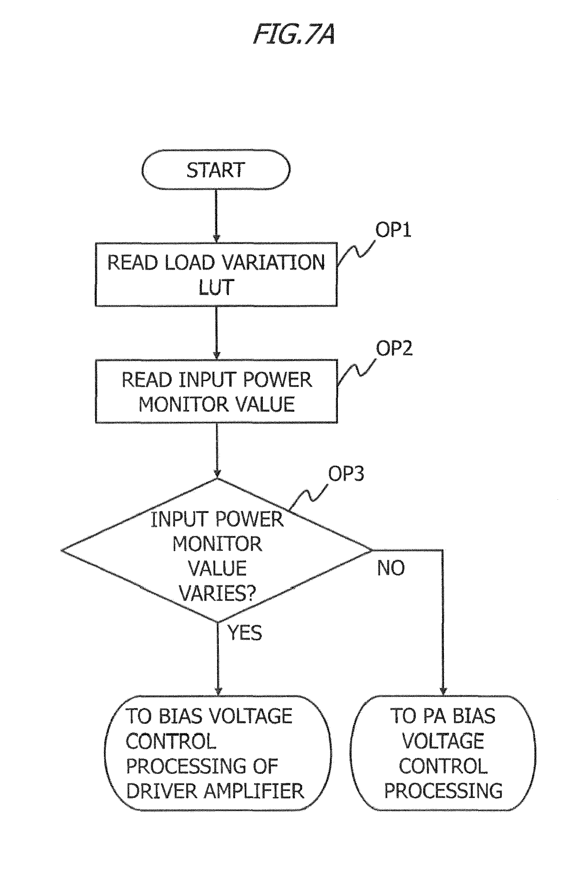

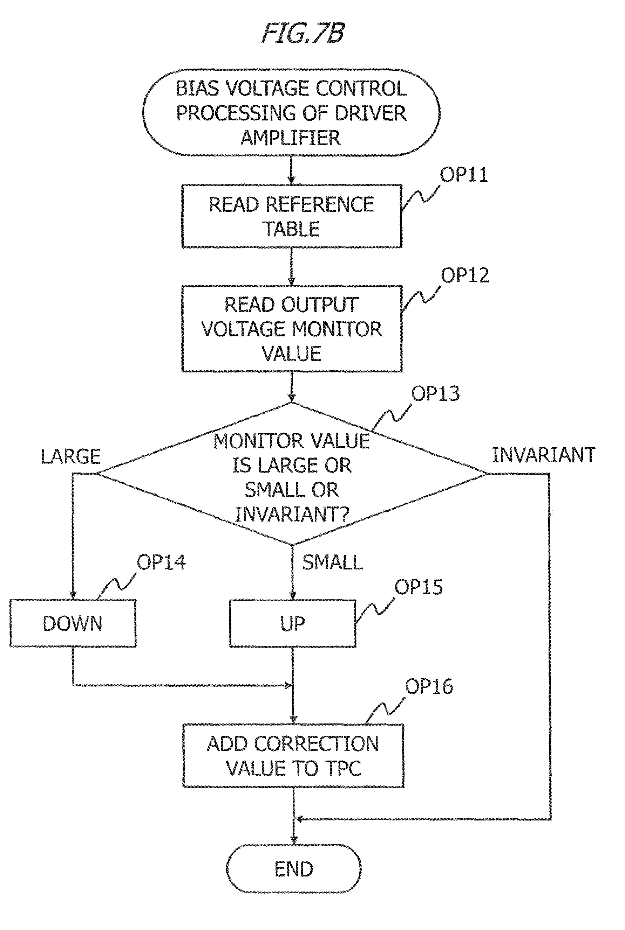

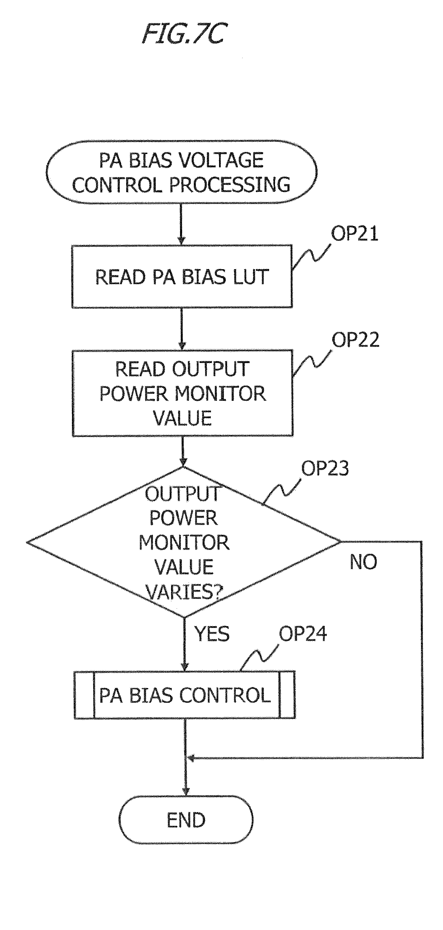

Figs. 7A, 7B and 7C are charts illustrating one example of processing of transmission power control of the transceiver 100. The flowchart illustrated in Fig. 7A is executed, for example, every 660 microseconds that is execution timing for the control processing of the APC 82, while the transceiver 100 is executing transmission processing.

In OP1, the load determination circuit 12 reads the reference value of the input power monitor value from the load variation lookup table 11. In OP2, the load determination circuit 12 reads the input power monitor value inputted by the input power monitor circuit 2 from, for example, the buffer for the input power monitor value.

In OP3, the load determination circuit 12 determines whether or not the input power monitor value varies from the reference value. If the input power monitor value varies from the reference value (OP3: Yes), the processing shifts to control processing of the bias voltage of the driver amplifier 7 by the APC 82 that is illustrated in Fig. 7B. This is because as a result that the input power monitor value is varied, it is determined that the gains of the power amplifier 5 and the driver amplifier 7 are varied due to an external factor such as a temperature change.

If the input power monitor value does not vary from the reference value (OP3: No), the processing shifts to the control processing of the PA bias voltage by the PA bias control circuit 13 that is illustrated in Fig. 7C. This is because as a result that the input power monitor value does not vary, it is determined that gain variations of the power amplifier 5 and the driver amplifier 7 due to an external factor such as a temperature change are not present. When the PA bias voltage control processing by the PA bias control circuit 13 is executed, the bias voltage control processing of the driver amplifier 7 is not executed. Therefore, the load determination circuit 12 outputs, for example, a standby signal to the APC 82 to cause the processing of the APC 82 to be on standby.

Fig. 7B illustrates a flowchart of bias voltage control processing of the driver amplifier 7 that is executed in the APC 82. The processing illustrated in Fig. 7B is started by the output power monitor value being inputted in the APC 82 from the load determination circuit 12.

In OP 11, the APC 82 reads the reference value of the output power monitor value at the reference temperature, and the reference table. The reference value of the output power monitor value at the reference temperature can be obtained from a table of the output power of the antenna 10 that is acquired in advance in the case of the reference temperature set as 25°C and the reference value of the PA bias voltage set as 3.5 V, like the load variation lookup table 11 illustrated in Fig. 5, for example. In the reference table, for example, the correction values for the bias voltage of the driver amplifier 7 by the TPC 81, that correspond to the output power monitor values is retained. In OP12, the APC 82 reads the output power monitor value.

In OP 13, the APC 82 determines whether or not the output power monitor value varies from the reference value that is read in OP 11. If the output power monitor value does not vary from the reference value (OP13: invariant), gain variations of the power amplifier 5 and the driver amplifier 7 are not recognized, and therefore, the processing illustrated in Fig. 7B is ended.

If the output power monitor value is larger than the reference value (OP13: larger), the processing proceeds to OP 14. If the output power monitor value is larger than the reference value, the temperature becomes lower than the reference temperature, and it is determined that the gains of the power amplifier 5 and the driver amplifier 7 become large. Therefore, the bias voltage of the driver amplifier 7 is controlled to be small so that the output power of the power amplifier 5 and the driver amplifier 7 becomes small. Accordingly, in OP 14, the APC 82 obtains the correction value that is a smaller value, from the reference table. Thereafter, the processing proceeds to OP 16.

If the output power monitor value is smaller than the reference value (OP13: smaller), the processing proceeds to OP 15. If the output power monitor value is smaller than the reference value, it is determined that the temperature becomes higher than the reference temperature, and the gains of the power amplifier 5 and the driver amplifier 7 become small. Therefore, the bias voltage of the driver amplifier 7 is controlled to be large so that the output power of the power amplifier 5 and the driver amplifier 7 becomes large. Accordingly, in OP 15, the APC 82 obtains a correction value that is a larger value from the reference table. Thereafter, the processing proceeds to OP 16.

In OP 16, the APC 82 outputs the correction value acquired in OP14 or OP15, and adds the correction value to the bias voltage of the driver amplifier 7 that is outputted from the TPC 81. Thereafter, the processing illustrated in Fig. 7B is ended.

Fig. 7C is one example of the flowchart of the bias voltage control processing of the power amplifier 5 by the PA bias control circuit 13. The processing illustrated in Fig. 7C is started by an instruction from the load determination circuit 12 when the load determination circuit 12 determines that the input power monitor value does not vary from the reference value.

In OP 21, the PA bias control circuit 13 reads the PA bias lookup table 14. In OP 22, the PA bias control circuit 13 reads the output power monitor value from, for example, the buffer for the output power monitor value.

In OP 23, the PA bias control circuit 13 determines whether or not the output power monitor value varies from the output power monitor value of the previous time. If the output power monitor value does not vary (OP 23: No), it is recognized that the gain of the power amplifier 5 does not vary. Therefore, control of the PA bias voltage is not performed, and the processing illustrated in Fig. 7C is ended.

If the output power monitor value varies from the output power monitor value of the previous time (OP 23: Yes), a variation of the gain of the power amplifier 5 is determined. In this case, the processing proceeds to OP 24, and the PA bias control circuit 13 performs control of the PA bias voltage. More specifically, the PA bias control circuit 13 acquires the PA bias voltage corresponding to the change amount of the output power monitor value, from the PA bias lookup table 14, and supplies the PA bias voltage to the power amplifier 5. Thereafter, the processing illustrated in Fig. 7C is ended.

### <Operation and Effect>

### (1) In the case of the gain variation due to an external factor such as a temperature change

When a gain variation due to an external factor such as a temperature change occurs, the input power monitor value varies from the reference value. Therefore, in the processing illustrated in Fig. 7A, by the load determination circuit 12, it is determined that the input power monitor value varies from the reference value, and it is determined that a gain variation due to an external factor such as a temperature change is present. Further, the control processing of the PA bias voltage by the PA bias control circuit 13 illustrated in Fig. 7C is not executed, the output power monitor value is outputted to the APC 82, and the control processing of the bias voltage of the driver amplifier 7 illustrated in Fig. 7B is executed. In the processing illustrated in Fig. 7B, by the APC 82, the correction value of the bias voltage of the TPC 81 corresponding to the variation of the input power monitor value is found, and the bias voltage of the driver amplifier 7 is controlled. Thereby, the variation of the output power corresponding to the gain variation due to an external factor such as a temperature change is corrected.

### (2) In the case of the gain variation due to the load variation by a reflected wave

When the gain variation due to the load variation by a reflected wave occurs, and the gain variation due to an external factor such as a temperature change does not occur, a variation from the reference value of the input power monitor value is not present. Further, in this case, the output power monitor value varies. Therefore, in the processing illustrated in Fig. 7A, by the load determination circuit 12, it is determined that the input power monitor value does not vary from the reference value, and the gain variation due to a load variation is determined. Further, the control processing of the bias voltage of the driver amplifier 7 by the APC 82 illustrated in Fig. 7B is not performed, and the control processing of the PA bias voltage by the PA bias control circuit 13 illustrated in Fig. 7C is performed. By the PA bias control circuit 13, the PA bias voltage corresponding to the change amount of the output power monitor value is found, and the PA bias voltage is controlled. Thereby, the variation of the output power corresponding to the gain variation due to the load variation by a reflected wave is corrected.

### (3) In the case of occurrence of both the gain variation due to an external factor such as a temperature change and the gain variation due to the load variation by a reflected wave

When the gain variation due to an external factor such as a temperature change, and the gain variation due to the load variation by a reflected wave occur, a variation from the reference value of the input power monitor value occurs, and further, a variation of the output power monitor value also occurs. Therefore, at first, in the processing illustrated in Fig. 7A, by the load determination circuit 12, it is determined that the input power monitor value varies from the reference value, and control processing of the bias voltage of the driver amplifier 7 illustrated in Fig. 7B is executed.

When the variation of the output power corresponding to the gain variation due to an external factor such as a temperature change is corrected by the bias voltage control processing of the driver amplifier 7 illustrated in Fig. 7A and Fig. 7B being executed once or a plurality of times, the input power monitor value is stabilized to the reference value.

Thereafter, in the processing illustrated in Fig. 7A, it is determined that a variation from the reference value of the input power monitor value is absent, and the PA bias voltage control processing by the PA bias control circuit 13 that is illustrated in Fig. 7C is performed. Thereby, by the PA bias control circuit 13, the PA bias voltage is controlled, the variation of the output power corresponding to the gain variation due to the load variation by a reflected wave is corrected, and the output power monitor value is stabilized to a predetermined value.

As above, in the first embodiment, the transceiver 100 first determines presence or absence of the gain variation due to an external factor such as a temperature change, based on the input power monitor value. When the transceiver 100 determines that the gain variation due to an external factor such as a temperature change is present, the transceiver 100 executes control corresponding to the gain variation due to the external factor such as a temperature change, such as the bias voltage control processing of the driver amplifier 7 illustrated in Fig. 7B, for example. When the transceiver 100 determines that a gain variation due to an external factor such as a temperature change is absent, the transceiver 100 determines presence or absence of the gain variation due to the load variation by a reflected wave from the output power monitor value. When the transceiver 100 determines that the gain variation due to the load variation by a reflected wave is present, the transceiver 100 executes control corresponding to the gain variation due to the load variation by a reflected wave, such as the PA bias voltage control processing illustrated in Fig. 7C, for example.

As above, when the transceiver 100 executes the control corresponding to the gain variation due to an external factor such as a temperature change, the transceiver 100 does not execute the control corresponding to the gain variation due to the load variation by a reflected wave. Further, when the transceiver 100 executes the control corresponding to the gain variation due to the load variation by a reflected wave, the transceiver 100 does not execute the control processing corresponding to the gain variation due to an external factor such as a temperature change. Thereby, the transceiver 100 does not doubly perform the processing for increasing the output power or the processing for decreasing the output power, and does not excessively increase or decrease the output power of the power amplifier. As a result, the transceiver 100 can stabilize the output power of the power amplifier.

### <Others>

In the first embodiment, the transceiver in which the output of the power amplifier is transmitted via the antenna is described. However, the device to which the art described in the first embodiment is applicable is not limited to the transceiver including the power amplifier that is connected to the antenna like the transceiver 100 of the first embodiment. The art described in the first embodiment is applicable to any device in which the driver amplifier and the power amplifier are included, and the power amplifier is connected to such a device that generates a reflected wave, for example.

## Claims

1. An amplification output control device, comprising:
a determination unit that determines presence or absence of a gain variation of a power amplifier based on a monitor value of input power from a driver amplifier to the power amplifier, and, when it is determined that the gain variation of the power amplifier is present, outputs a monitor value of output power of the power amplifier to a driver control unit to cause the driver control unit to execute control of a bias voltage of the driver amplifier, wherein the driver control unit controls the bias voltage of the driver amplifier in response to the monitor value of the output power of the power amplifier; and
a control unit that determines the presence or absence of the gain variation of the power amplifier based on the monitor value of the output power of the power amplifier when it is determined that the gain variation of the power amplifier is absent based on the monitor value of the input power to the power amplifier, and, when it is determined that the gain variation of the power amplifier is present, controls a bias voltage of the power amplifier.

2. The amplification output control device according to claim 1, further comprising:
a storage unit that stores a reference value of the monitor value of the input power from the driver amplifier to the power amplifier,
wherein the determination unit compares the monitor value of the input power to the power amplifier and the reference value, and determines that the gain variation of the power amplifier is present, when the monitor value of the input power to the power amplifier and the reference value differ from each other.

3. The amplification output control device according to claim 1 or 2,
wherein the determination unit transmits a standby instruction to cause control of the bias voltage of the driver amplifier to be on standby to the driver control unit, when it is determined that the gain variation of the power amplifier is absent based on the monitor value of the input power to the power amplifier.

4. The amplification output control device according to any one of claims 1 to 3,
wherein the control unit determines presence or absence of a variation from a predetermined reference value of the monitor value of the output power of the power amplifier, and determines that the gain variation of the power amplifier is present when the variation from the predetermined reference value of the monitor value of the output power of the power amplifier is present.

5. The amplification output control device according to any one of claims 1 to 4, further comprising:
a second storage unit that stores the bias voltage of the power amplifier corresponding to a change amount of the output power of the power amplifier,
wherein the control unit acquires the bias voltage of the power amplifier corresponding to a change amount of the monitor value of the output power of the power amplifier from the second storage unit.

6. An amplification output control method executed by an amplification output control device, the method comprising:
determining presence or absence of a gain variation of a power amplifier based on a monitor value of input power from a driver amplifier to the power amplifier, and, when it is determined that the gain variation of the power amplifier is present, outputting a monitor value of output power of the power amplifier to a driver control unit to cause the driver control unit to execute control of a bias voltage of the driver amplifier, wherein the driver control unit controls the bias voltage of the driver amplifier in response to the monitor value of the output power of the power amplifier; and
determining the presence or the absence of the gain variation of the power amplifier based on the monitor value of the output power of the power amplifier when it is determined that the gain variation of the power amplifier is absent based on the monitor value of the input power to the power amplifier, and, when it is determined that the gain variation of the power amplifier is present, controlling a bias voltage of the power amplifier.
